# EUROPÄISCHE PATENTANMELDUNG

(11) **EP 2 133 920 A2**
(43) Veröffentlichungstag der Anmeldung: **16.12.2009**
(21) Anmeldenummer: 09157256.0
(22) Anmeldetag: 03.04.2009
(51) Int. Cl.: H01L 31/02, H01L 31/042

(54) **Verbindung von Solarmodulen**

(30) Priorität: 15.05.2008 DE 102008023643
(71) Anmelder: Siemens AG, Wittelsbacher Platz 2 80333 München (DE)
(72) Erfinder: Farid, Ahmed, 91054, Buckenhof (DE)

(57) **Zusammenfassung**

Die Erfindung betrifft ein Solarmodul mit einem Gehäuse, wobei das Gehäuse zwei Seitenwände sowie vier weitere Gehäusewände aufweist, und mit zumindest zwei Kontaktelementen, die je eine Kontaktfläche aufweisen, zur elektrischen Kontaktierung des Solarmoduls, wobei zumindest ein Kontaktelement mit einer positiven und zumindest ein Kontaktelement mit einer negativen inneren Anschlussleitung des Solarmoduls elektrisch leitend verbunden ist. Der Erfindung liegt die Aufgabe zugrunde, Solarmodule anzugeben, die unter Vermeidung der Nachteile der bekannten Lösungen, wie hoher Montageaufwand und Leitungsverluste durch häufige Kabelverbindungen, zu Fotovoltaikgeneratoren zusammengeschlossen werden können. Diese Aufgabe wird dadurch gelöst, dass die zumindest zwei Kontaktelemente an je einer Seitenwand angeordnet sind, wobei die Kontaktelemente an gegenüberliegenden Seiten jeweils an der gleichen Stelle angeordnet werden, so dass sie beim Zusammenschieben bzw. -stecken der Solarmodule elektrisch miteinander in Kontakt gebracht werden.

## Beschreibung

Die Erfindung betrifft ein Solarmodul mit einem Gehäuse, wobei das Gehäuse zwei Seitenwände sowie vier weitere Gehäusewände aufweist, und mit zumindest zwei Kontaktelementen, die je eine Kontaktfläche aufweisen, zur elektrischen Kontaktierung des Solarmoduls, wobei zumindest ein Kontaktelement mit einer positiven und zumindest ein Kontaktelement mit einer negativen inneren Anschlussleitung des Solarmoduls elektrisch leitend verbunden ist.

Ein derartiges Solarmoduls kommt insbesondere in Fotovoltaikanlagen bzw. Solarkraftwerken zum Einsatz. Photovoltaikanlagen bzw. Solarkraftwerke dienen der Einspeisung von elektrischem Strom in ein elektrisches Netz, wie z.B. in ein 1-phasiges 50Hz/230V-Spannungsnetz oder in ein 3-phasiges 50Hz/400V-Spannungsnetz. Dazu können Photovoltaikanlagen ein oder mehrere Photovoltaikgeneratoren aufweisen, wobei ein Photovoltaikgenerator aus einem oder mehreren Solarmodulen bestehen kann, welches bzw. welche wiederum eine Vielzahl von untereinander verschalteten Solarzellen aufweisen können. Dabei werden üblicherweise die Solarzellen eines Solarmoduls als "String" in Reihe, insbesondere mäanderförmig geschaltet. Der auf photovoltaischem Weg erzeugte elektrische Strom wird dann einem oder mehreren Wechselrichtern zugeführt, welcher oder welche die zugeführte Niedervoltspannung in eine geregelte standardisierte Netzspannung umwandelt.

Um mehrere Solarmodule zu einem Fotovoltaikgenerator zusammenzuschließen, weisen die bekannten Solarmodule der verschiedensten Anbieter in der Mitte ihrer Rückseite eine zweipolige Anschlussbox auf, über die eine elektrisch leitende Verbindung zu den Nachbarmodulen hergestellt wird, wobei von benachbarten Solarmodulen ausgehende Kabel über einen Verbindungsstecker miteinander verbunden werden. Nachteilig hieran ist der hohe Verkabelungsaufwand sowie die damit verbundenen Kabelverluste.

Sind die Kontaktelemente - wie z.B. in JP 09135039 A - im unmittelbaren Bereich je einer Seitenwand angeordnet, so kann die elektrische Verbindung benachbarter Solarmodule beispielsweise mittels einer flexiblen Kabelverbindung - oder über andere Verbindungsvorrichtungen wie in JP 09135039 - erfolgen, wobei die benötigten Kabellängen sehr kurz sind und zudem keine Verbindungsstecker mehr benötigt werden. Durch den hieraus resultierenden Wegfall der Verbindungs-Kabelverluste verbessert sich vorteilhaft die Performance Ratio. Zusätzliche Vorteile ergeben sich aus der Einsparung von Kabelverbindungen, Steckern und Steckboxen sowie an Montagezeiten durch die erhebliche Vereinfachung der Montage. Dabei sind diese Einsparungen bei einer typischen Breite eines Solarmoduls im Bereich von etwa einem Meter insbesondere bei größeren Fotovoltaikanlagen bzw. Solarkraftwerken durchaus erheblich.

Der Erfindung liegt die Aufgabe zugrunde, Solarmodule anzugeben, die unter Verbesserung der bekannten Lösungen zu Fotovoltaikgeneratoren zusammengeschlossen werden können.

Diese Aufgabe wird bei einem Solarmodul der eingangs genannten Art dadurch gelöst, dass die zumindest zwei Kontaktelemente an je einer Seitenwand angeordnet sind, wobei die Kontaktelemente an gegenüberliegenden Seiten jeweils an der gleichen Stelle angeordnet werden, so dass sie beim Zusammenschieben bzw. -stecken der Solarmodule elektrisch miteinander in Kontakt gebracht werden.

Werden die Kontaktelemente an je einer Seitenwand angeordnet so vergrößern sich nicht nur die oben genannten Vorteile, sondern es wird zusätzlich noch die Fehlersicherheit erhöht, da eine fehlerhafte Montage nun nicht mehr möglich ist. Die erfindungsgemäßen Solarmodule werden durch einfaches Zusammenschieben bzw. -stecken zu einem Fotovoltaikgenerator zusammengeschlossen. Es versteht sich hierbei von selbst, dass die Kontaktelemente an gegenüberliegenden Seiten jeweils an der gleichen Stelle angeordnet werden, so dass sie beim Zusammenschieben bzw. -stecken der Solarmodule elektrisch miteinander in Kontakt gebracht werden. Hierfür sind die Kontaktelemente in geeigneter Weise auszuführen, wobei besonders vorteilhafte Ausführungsformen den Unteransprüchen zu entnehmen sind.

In einer vorteilhaften Form der Ausgestaltung weist zumindest ein Kontaktelement ein Kontaktelementgehäuse auf, das mittels eines Befestigungselementes mit dem Gehäuse des Solarmoduls verbunden ist. Dies erleichtert das Anbringen des Kontaktelements in einer dafür vorgesehenen Ausnehmung im Gehäuse des Solarmoduls, wobei auch zusätzlich die zum Kontaktelement gehörenden Bauteile baulich vom sonstigen Innenleben des Solarmoduls getrennt sind.

In einer weiteren vorteilhaften Ausführungsform weist dabei das Befestigungselement Mittel zum Herstellen einer lösbaren mechanischen Verbindung auf. Dies kann beispielsweise durch eine Einrastvorrichtung oder durch eine einfache Schraubverbindung realisiert sein. Hierdurch kann beispielsweise ein defektes Kontaktelement einfach ausgetauscht werden.

In einer weiteren vorteilhaften Ausführungsform weist zumindest ein Kontaktelement eine Dichtung auf, die einen Bereich um die Kontaktfläche umschließt, wobei die Dichtung außerhalb des Gehäuses des Solarmoduls angeordnet ist. Diese Dichtung trifft somit beim Zusammenschieben bzw. -stecken benachbarter Solarmodule auf eine entsprechende Dichtung des zu kontaktierenden Kontaktelementes, so dass der entstehende Kontakt vor Korrosionseinflüssen geschützt ist.

In einer weiteren vorteilhaften Ausführungsform ist die Kontaktfläche zumindest eines Kontaktelements gefettet und/oder aufgeraut ausgeführt. Hierdurch wird eine sichere und dauerhafte elektrische Verbindung der Solarmodule gewährleistet.

In einer weiteren vorteilhaften Ausführungsform ist die Kontaktfläche zumindest eines Kontaktelements gefedert ausgeführt. Hierdurch wird zusätzlich die Sicherheit und Dauerhaftigkeit der elektrischen Verbindung weiter erhöht.

In einer weiteren vorteilhaften Ausführungsform weist zumindest ein Kontaktelement ein Federelement auf, auf dem die Kontaktfläche angeordnet ist. Auf diese Weise ist nicht nur die Kontaktfläche selbst gefedert, sondern diese ist als Ganzes durch das Federelement in ihrer Lage verschiebbar, wobei das Herstellen einer elektrischen Verbindung zwischen den Solarmodulen beim Zusammenschieben selbiger erleichtert wird. Zudem erlaubt diese Federung eine zusätzliche Kontakttoleranz in Höhe und Neigung der Solarmodule.

In einer weiteren vorteilhaften Ausführungsform weist das Federelement dabei zumindest eine Druckfeder auf. Hierbei kann die Druckfeder einfach in einer zylinderförmigen Ausnehmung angeordnet sein, in die ein Teil des Federelementes ragt, auf dem die Kontaktfläche angeordnet ist.

In einer weiteren vorteilhaften Ausführungsform weist dabei das Federelement zumindest einen Federkolben samt Haltescheibe und Führungsring auf. Bei dieser Ausführungsform umschließt die Druckfeder den hinteren Teil des Federkolbens, wobei die Kontaktfläche auf dem vorderen Teil des Kolbens befestigt ist. Hierbei verhindert die Haltescheibe ein zu tiefes Hineindrücken des Federkolbens in das Solarmodul, während der Führungsring für die korrekte Positionierung des Kolbens sorgt.

In einer weiteren vorteilhaften Ausführungsform weist zumindest ein Kontaktelement einen Kontaktträger auf, an dem die Kontaktfläche befestigt ist. Diese bauliche Ausgestaltung ist insbesondere bei nicht-ebenen Kontaktflächen von Vorteil, die vom Kontaktträger durch eine Befestigung auch an nur wenigen Stellen in der richtigen Position gehalten werden können.

In einer weiteren vorteilhaften Ausführungsform ist dabei der Kontaktträger auf einem Federmechanismus angeordnet. Dies ermöglicht auch bei der oben genannten Ausgestaltung eine gewisse Kontakttoleranz und gewährleistet darüber hinaus eine sichere Verbindung der Solarmodule.

In einer weiteren vorteilhaften Ausführungsform ist die Kontaktfläche zumindest eines Kontaktelements trichterförmig ausgeführt. Dabei sind bei einer Anordnung der Kontaktelemente an gegenüberliegenden Seitenwänden die jeweiligen Kontaktflächen derart auszuführen, dass beim Zusammenschieben benachbarter Solarmodule die zu kontaktierenden Kontaktelemente ineinander greifen. Auf diese Weise wird eine passgenaue Kontaktverbindung erzielt.

In einer weiteren vorteilhaften Ausführungsform ist zumindest ein Kontaktelement als Kontaktbuchse für eine Steckverbindung ausgeführt. Dies ermöglicht - je nach Ausbildung der Kontaktbuchse - beispielsweise die Verwendung von standardisierten Steckern für eine standardisierte Kabelverbindung, wobei die Kontaktelemente hierfür z.B. auch an der Rückseite des Gehäuses des Solarmoduls angeordnet sein können, oder auch die Verwendung einer passgenauen, trichterförmigen Steckverbindung.

In einer weiteren vorteilhaften Ausführungsform ist zumindest ein Kontaktelement als Kontaktstecker für eine Steckverbindung ausgeführt. Die Vorteile entsprechen dabei den eben genannten.

In einer weiteren vorteilhaften Ausführungsform ist zumindest ein Kontaktelement als Druckkontakt ausgeführt. Hierfür eignen sich natürlich in besonderer Weise Ausgestaltungen, bei denen eine Federung ein fehlertolerantes Zusammenschieben gestattet, wodurch ein besonders einfacher Aufbau eines Solargenerators, bestehend aus mehreren Solarmodulen, ermöglicht wird.

Im Folgenden wird die Erfindung anhand der in den Figuren dargestellten Ausführungsbeispiele näher beschrieben und erläutert. Es zeigen:
- FIG 1: in Reihe geschaltete herkömmliche Solarmodule,
- FIG 2: in Reihe geschaltete verbesserte Solarmodule nach Stand der Technik,
- FIG 3: in Reihe geschaltete erfindungsgemäße Solarmodule,
- FIG 4: zwei benachbarte Solarmodule mit einem ersten erfindungsgemäßen Kontaktelement,
- FIG 5: das Kontaktelement aus FIG 4 in einer Draufsicht,
- FIG 6: zwei benachbarte Solarmodule mit einem zweiten erfindungsgemäßen Kontaktelement,
- FIG 7: das Kontaktelement aus FIG 6 in einer Draufsicht,
- FIG 8: zwei benachbarte Solarmodule mit einem dritten erfindungsgemäßen Kontaktelement,
- FIG 9: das Kontaktelement aus FIG 8 in einer Draufsicht.

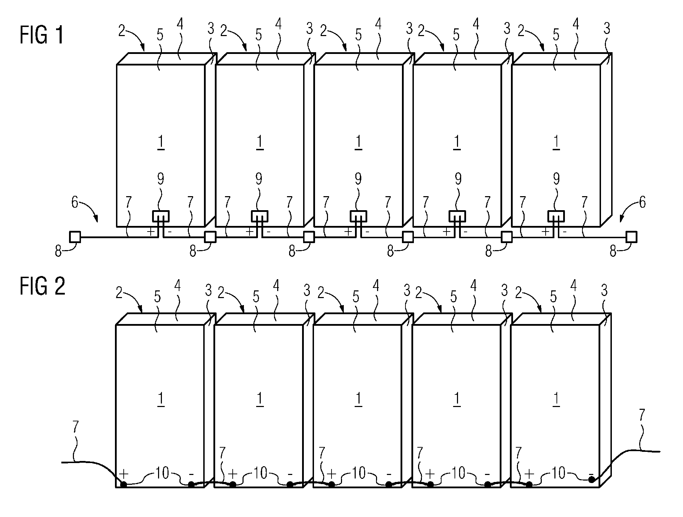

FIG 1 zeigt mehrere in Reihe geschaltete Solarmodule 1 nach Stand der Technik. Die Solarmodule 1 weisen ein Gehäuse 2 auf, wobei das Gehäuse 2 aus zwei Seitenwänden 3 und vier weiteren Gehäusewänden 4, 5, von denen eine die Rückwand 5 ist, besteht. Die Solarmodule 1 sind mit einer herkömmlichen Kabelverbindung 6 elektrisch miteinander verbunden. Dabei wird die herkömmliche Kabelverbindung 6 gewöhnlich über so genannte "Solarkabel" 7 hergestellt, die untereinander über 2-Kontakt-Verbindungsstecker (Steckboxen) 8 und mit den Solarmodulen 1 über eine 2-polige Anschlussbox 9 verbunden sind. Die Solarkabel 7 haben dabei typischerweise einen Durchmesser von 4 mm². Die 2-poligen Anschlussboxen 9 sind jeweils auf der Rückseite 5 des Gehäuses 2 der Solarmodule 1 angebracht. Bei typischen Ausmaßen eines Solarmoduls 1 von ungefähr einer Breite von 1000 mm (bei einer Höhe von ca. 1700 mm) ergeben sich für einen Solargenerator und erst recht für eine komplette Fotovoltaikanlage bzw. ein Solarkraftwerk durchaus erhebliche Kabellängen für die Kabelverbindung 6. Hinzu kommt der Montageaufwand für die jeweils zwischen den Solarmodulen 1 zwischengeschalteten Steckboxen 8 sowie die damit verbundenen Verbindungs-Kabelverluste.

FIG 2 zeigt mehrere in Reihe geschaltete Solarmodule 1, wie sie grundsätzlich auch aus dem Stand der Technik bekannt sind. Hier sind die Kontaktelemente 10 in der Rückwand 5 des Gehäuses 2 des Solarmoduls 1 im unmittelbaren Bereich der Seitenwände 3 angeordnet. Hierdurch ist es möglich, die elektrische Verbindung zwischen zwei benachbarten Modulen 1 durch kurze und flexible Kabelverbindungen, für die beispielsweise ebenfalls (kurze) Solarkabel 7 verwendet werden können, zu bewerkstelligen. Hierzu können die Kontaktelemente 10 als standardisierte Kontaktbuchsen für Standard-Steckverbindungen ausgebildet sein. Hieraus ergibt sich nicht nur eine Einsparung sowohl von Kabelverbindungen, Steckern und Steckboxen, sondern auch von Montagezeiten. Besonders von Vorteil ist natürlich die Verbesserung der Performance Ratio durch den Wegfall der Verbindungs-Kabelverluste.

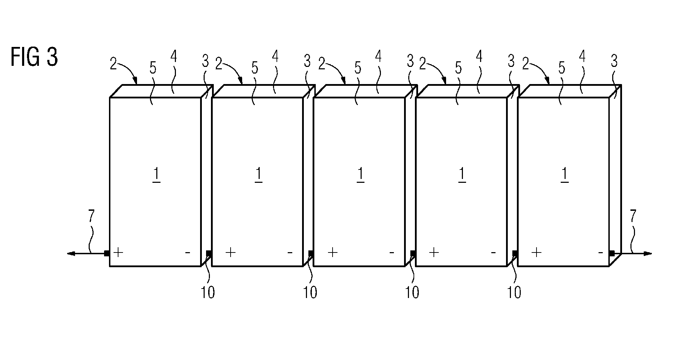

FIG 3 zeigt Solarmodule 1 wie in FIG 2 in einer Ausführungsform gemäß der Erfindung. Bei dieser sind die Kontaktelemente 10 jeweils in einer Seitenwand 3 des Gehäuses 2 des Solarmoduls 1 angebracht. Dabei können die Kontaktelemente 10 als (einpolige) Steck- oder Druck-Verbindungen realisiert sein. Die Verbindungen vom ersten und letzten Solarmodul 1 können durch je ein Solarkabel 7 hergestellt werden, wobei ein String von in Reihe geschalteten Modulen 1 (anders als dargestellt) typischerweise aus ca. 20 Solarmodulen 1 besteht.

Durch die seitliche Anbringung der Kontaktelemente 10 kann auf eine Verkabelung vollständig verzichtet werden, so dass sich die Einsparungen im Vergleich zum im FIG 2 gezeigten Ausführungsbeispiel weiter erhöht. Zudem wird bei dem in FIG 3 gezeigten Ausführungsbeispiel die Montage noch einmal erheblich vereinfacht, da die Solarmodule 1 nunmehr gar nicht mehr verkabelt werden müssen, sondern nur noch durch bloßes Zusammenschieben bzw. -stecken miteinander in elektrischen Kontakt gebracht werden. Hierdurch wird zusätzlich die Fehlersicherheit erheblich erhöht, da eine fehlerhafte Verkabelung nicht mehr möglich ist.

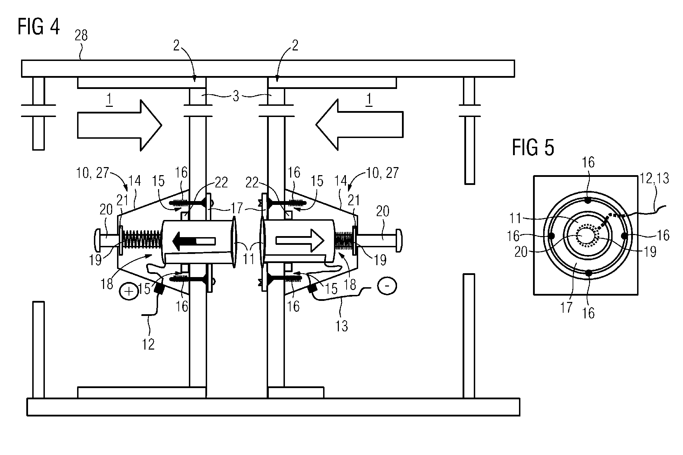

FIG 4 zeigt zwei Solarmodule 1 in einer Querschnittansicht, wobei zwei Kontaktelemente 10 jeweils in einer Seitenwand 3 des jeweiligen Gehäuses 2 der entsprechenden Solarmodule 1 an korrespondierender Stelle derart angebracht sind, dass sie beim Zusammenschieben der Module 1 eine elektrisch leitende Verbindung eingehen. Die dargestellten Kontaktelemente 10 sind also somit als Druckkontakt 27 ausgeformt. Dabei ist das linke Kontaktelement 10 mit einer positiven inneren Anschlussleitung 12 des linken Solarmoduls 1 und das rechte Kontaktelement 10 mit einer negativen inneren Anschlussleitung 13 des rechten Moduls 1 verbunden. Die Module 1 sind in einem Gestell 28 untergebracht, das für ungefähr zwanzig Solarmodule Platz bietet.

Die (identisch aufgebauten) Kontaktelemente 10 weisen ein Kontaktelementgehäuse 14 auf, das über Befestigungsmittel 15 mit dem Gehäuse 2 des Solarmoduls 1 verbunden ist, wobei das Befestigungselement 15 Mittel zum Herstellen einer lösbaren mechanischen Verbindung 16 aufweist, als die - wie im dargestellten Fall - beispielsweise einfache Senkkopfschrauben 16 dienen können. Die eigentliche Kontaktfläche 11 des Kontaktelementes 10 ist auf einem Federelement 18 angebracht, das einen Federkolben 20 aufweist und mittels einer Druckfeder 19 mit einer nach außen gerichteten Kraft beaufschlagt ist (das heißt die Kraft wirkt senkrecht zur Fläche der Seitenwand 3 des Gehäuses 2 des Solarmoduls 1). Dabei stützt sich die Druckfeder 19 an einer Haltescheibe 21 ab, die an einer der Seitenwand 3 gegenüberliegenden Seite des Kontaktelementgehäuses 14 angeordnet ist, wobei das an dieser Seite liegende Ende des Federkolbens 20 durch eine Ausnehmung des Kontaktelementgehäuses 14 ragt.

Beim Zusammenschieben der Solarmodule 1 werden die Federelemente 18 der Kontaktelemente 10 zusammengedrückt, wodurch - bei gleichzeitiger Herstellung einer elektrischen Verbindung zwischen den Modulen 1 - die Federelemente 18 samt darauf angebrachter Kontaktfläche 11 in das jeweilige Solarmodul 1 hinein geschoben werden. Die Figur zeigt das linke Kontaktelement 10 mit einem Federelement 18 in einem halb eingeschobenen Zustand - dargestellt durch den halb-weißen Pfeil, d.h. die Feder 19 ist nur teilweise zusammengedrückt -, während das rechte Kontaktelement 10 mit einem Federelement 18 im ganz eingeschobenen Zustand gezeigt ist - dargestellt durch den weißen Pfeil, d.h. die Feder 19 ist vollständig zusammengedrückt.

Zur Gewährleistung einer sicheren und dauerhaften elektrischen Verbindung sind die Oberflächen der Kontaktflächen 11 gefettet und aufgeraut. Um den Bereich der Kontaktflächen 11 herum ist eine Dichtung angebracht, die vorteilhafterweise ringförmig ausgeführt ist und die beim Zusammenschieben der Solarmodule 1 mit ihrem jeweiligen Gegenpart in Kontakt gebracht wird, so dass Korrosionseinflüsse verhindert werden. Die gefederten, gefetteten und aufgerauten Kontaktoberflächen 11 gewährleisten einen sicheren und dauerhaften Kontakt der Module 1, wobei die angebrachten Federungen zusätzlich eine Kontakt-Toleranz in Höhe und Neigung der Module 1 erlauben.

FIG 5 zeigt eine Draufsicht des Kontaktelementes 10 aus FIG 4, wobei die dargestellte Anschlussleitung wahlweise die positive innere Anschlussleitung 12 des linken Moduls 1 oder die negative innere Anschlussleitung 13 des rechten Moduls 1 ist. Der Kreis in der Mitte stellt den zylinderförmigen Federkolben 20 dar, der von der Druckfeder 19 umschlossen ist, die die Kontaktfläche 11 nach außen drückt. Umgeben ist die Kontaktfläche 11 von der ringförmigen Dichtung 17, während das gesamte Kontaktelement 10 über vier Senkkopfschrauben 16 am Gehäuse 2 des Solarmoduls 1 befestigt ist.

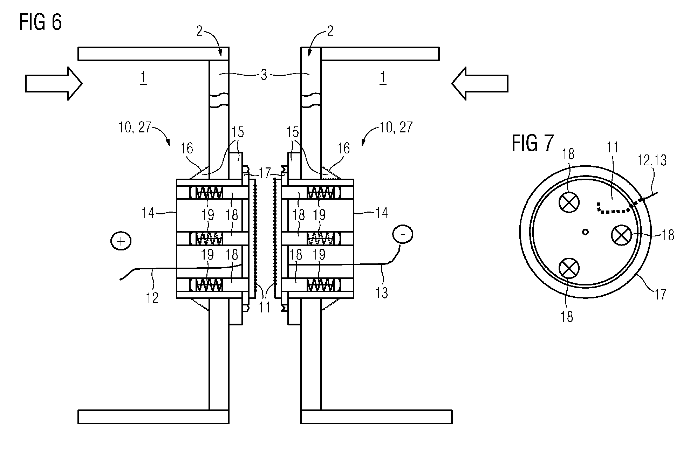

FIG 6 zeigt zwei nebeneinander liegende Solarmodule 1 - ähnlich wie in FIG 4, nur ohne das Gestell 28 - mit in der Seitenwand 3 des Gehäuses 2 angebrachten Kontaktelementen 10. Genauso wie bei den Kontaktelementen 10 der FIG 4 handelt es sich hier um Druckkontakte 27. Wiederum ist die Kontaktfläche 11 des linken Kontaktelementes 10 mit der positiven inneren Anschlussleitung 12 des linken Solarmoduls 1 verbunden, während die Kontaktfläche 11 des rechten Kontaktelementes 10 mit der negativen inneren Anschlussleitung 13 des rechten Solarmoduls 1 verbunden ist. Ebenso wie in FIG 4 ist die jeweilige Kontaktfläche 11 auf einem Federelement 18 angebracht, wobei das Federelement 18 im jeweiligen Kontaktelement 10 drei Druckfedern 19 aufweist, die sich in dafür vorgesehenen Ausnehmungen des Kontaktelementgehäuses 14 am Kontaktelementgehäuse 14 abstützen. Das Kontaktelementgehäuse 14 (und damit auch natürlich das Kontaktelement 10) ist über eine Befestigungsvorrichtung 15 am Gehäuse 2 befestigt, wobei ein Einrast-Befestigungssystem 16 als Mittel zum Herstellen einer lösbaren mechanischen Verbindung dient. Eine Dichtung 17, die den Bereich um die Kontaktflächen 11 umschließt, sorgt auch hier für eine Verhinderung von Korrosionseinflüssen. Zur Gewährleistung eines sicheren und dauerhaften Kontaktes sind die Kontaktflächen 11 wiederum gefedert, gefettet und aufgeraut. Zudem bietet besonders diese Ausführungsform mit drei Druckfedern 19 eine hohe Kontakt-Toleranz in Höhe und Neigung der Module 1.

FIG 7 zeigt das Kontaktelement 10 aus FIG 6 in einer Draufsicht, in der insbesondere die Positionierung der Druckfedern 19 gut zu erkennen ist. Die Anschlussleitung ist wieder wahlweise die positive 12 des linken oder die negative 13 des rechten Moduls 1. die Kontaktfläche 11 ist von der ringförmigen Dichtung 17 umgeben, die beim Zusammenschieben der Module 1 mit ihrem Gegenpart in Kontakt gebracht wird und so zusammen mit diesem einen Schutz gegen Korrosionseinflüsse bewirkt.

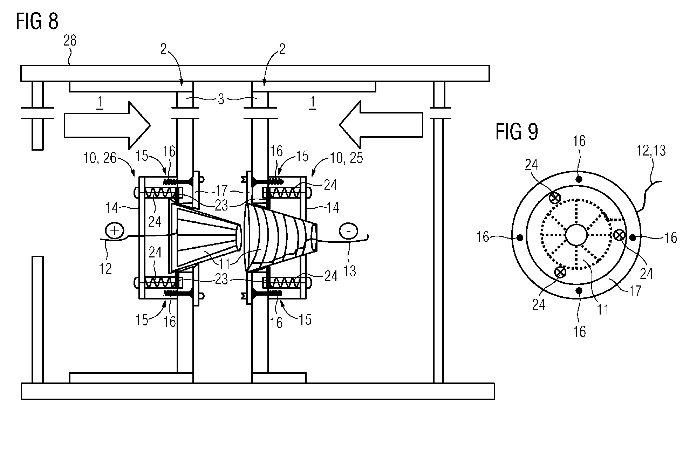

FIG 8 zeigt wieder in nebeneinander angeordneten Solarmodulen 1 angebrachte Kontaktelemente 10. die Kontaktflächen 11 sind gefedert und derart trichterförmig ausgestaltet, dass sie beim Zusammenschieben der Module 1 ineinandergreifen. Die Kontaktflächen 11 sind an einem Kontaktträger 23 befestigt, der seinerseits auf einem Federmechanismus 24 gelagert ist, wobei der Federmechanismus 24 durch in Ausnehmungen des Kontaktelementgehäuses 14 befindliche Druckfedern gebildet wird. Diese Kontaktelemente 10 bilden also eine Steckverbindung, bei der das linke Kontaktelement 10 als Kontaktstecker 26 und das rechte Kontaktelement 10 als Kontaktbuchse 25 ausgebildet ist. Für eine Erläuterung der weiteren Bezugszeichen vgl. die Beschreibung zu FIG 4 und FIG 6.

FIG 9 zeigt eine Draufsicht des Kontaktelementes 10 aus FIG 8 mit der (sektorierten und gefederten) Kontaktfläche 11 des linken Moduls 1. Der Federmechanismus 24 weist drei Druckfedern auf, deren Positionen in der Figur dargestellt sind. Für eine Erläuterung der weiteren Bezugszeichen wird auf die Beschreibungen der Figuren 4 - 8 verwiesen.

Zusammenfassend betrifft die Erfindung ein Solarmodul mit einem Gehäuse, wobei das Gehäuse zwei Seitenwände sowie vier weitere Gehäusewände aufweist, und mit zumindest zwei Kontaktelementen, die je eine Kontaktfläche aufweisen, zur elektrischen Kontaktierung des Solarmoduls, wobei zumindest ein Kontaktelement mit einer positiven und zumindest ein Kontaktelement mit einer negativen inneren Anschlussleitung des Solarmoduls elektrisch leitend verbunden ist. Der Erfindung liegt die Aufgabe zugrunde, Solarmodule anzugeben, die unter Vermeidung der Nachteile der bekannten Lösungen, wie hoher Montageaufwand und Leitungsverluste durch häufige Kabelverbindungen, zu Fotovoltaikgeneratoren zusammengeschlossen werden können. Diese Aufgabe wird dadurch gelöst, dass die zumindest zwei Kontaktelemente an je einer Seitenwand angeordnet sind, wobei die Kontaktelemente an gegenüberliegenden Seiten jeweils an der gleichen Stelle angeordnet werden, so dass sie beim Zusammenschieben bzw. -stecken der Solarmodule elektrisch miteinander in Kontakt gebracht werden.

## Patentansprüche

1. Solarmodul (1) mit einem Gehäuse (2), wobei das Gehäuse (2) zwei Seitenwände (3) sowie vier weitere Gehäusewände (4, 5) aufweist, und mit zumindest zwei Kontaktelementen (10), die je eine Kontaktfläche (11) aufweisen, zur elektrischen Kontaktierung des Solarmoduls (1), wobei zumindest ein Kontaktelement (10) mit einer positiven (12) und zumindest ein Kontaktelement (10) mit einer negativen inneren Anschlussleitung (13) des Solarmoduls (1) elektrisch leitend verbunden ist, **dadurch gekennzeichnet, dass** die zumindest zwei Kontaktelemente (10) an je einer Seitenwand (3) angeordnet sind, wobei die Kontaktelemente an gegenüberliegenden Seiten jeweils an der gleichen Stelle angeordnet werden, so dass sie beim Zusammenschieben bzw. -stecken der Solarmodule elektrisch miteinander in Kontakt gebracht werden.

2. Solarmodul nach Anspruch 1,
wobei zumindest ein Kontaktelement (10) ein Kontaktelementgehäuse (14) aufweist, das mittels eines Befestigungselementes (15) mit dem Gehäuse (2) des Solarmoduls (1) verbunden ist.

3. Solarmodul nach Anspruch 2,
wobei das Befestigungselement (15) Mittel zum Herstellen einer lösbaren mechanischen Verbindung (16) aufweist.

4. Solarmodul nach einem der vorhergehenden Ansprüche,
wobei zumindest ein Kontaktelement (10) eine Dichtung (17) aufweist, die einen Bereich um die Kontaktfläche (11) umschließt, wobei die Dichtung (17) außerhalb des Gehäuses (2) des Solarmoduls (1) angeordnet ist.

5. Solarmodul nach einem der vorhergehenden Ansprüche,
wobei die Kontaktfläche (11) zumindest eines Kontaktelements (10) gefettet und/oder aufgeraut ausgeführt ist.

6. Solarmodul nach einem der vorhergehenden Ansprüche,
wobei die Kontaktfläche (11) zumindest eines Kontaktelements (10) gefedert ausgeführt ist.

7. Solarmodul nach einem der vorhergehenden Ansprüche,
wobei zumindest ein Kontaktelement (10) ein Federelement (18) aufweist, auf dem die Kontaktfläche (11) angeordnet ist.

8. Solarmodul nach Anspruch 7,
wobei das Federelement (18) zumindest eine Druckfeder (19) aufweist.

9. Solarmodul nach Anspruch 7 oder 8,
wobei das Federelement (18) zumindest einen Federkolben (20) samt Haltescheibe (21) und Führungsring (22) aufweist.

10. Solarmodul nach einem der vorhergehenden Ansprüche,
wobei zumindest ein Kontaktelement (10) einen Kontaktträger (23) aufweist, an dem die Kontaktfläche (11) befestigt ist.

11. Solarmodul nach Anspruch 10,
wobei der Kontaktträger (23) auf einem Federmechanismus (24) angeordnet ist.

12. Solarmodul nach einem der vorhergehenden Ansprüche,
wobei die Kontaktfläche (11) zumindest eines Kontaktelements (10) trichterförmig ausgeführt ist.

13. Solarmodul nach einem der vorhergehenden Ansprüche,
wobei zumindest ein Kontaktelement (10) als Kontaktbuchse (25) für eine Steckverbindung ausgeführt ist.

14. Solarmodul nach einem der vorhergehenden Ansprüche,
wobei zumindest ein Kontaktelement (10) als Kontaktstecker (26) für eine Steckverbindung ausgeführt ist.

15. Solarmodul nach einem der vorhergehenden Ansprüche,
wobei zumindest ein Kontaktelement (10) als Druckkontakt (27) ausgeführt ist.
